# EUROPÄISCHE PATENTSCHRIFT

(11) **EP 1 910 854 B1**
(45) Veröffentlichungstag und Bekanntmachung des Hinweises auf die Patenterteilung: **28.01.2009**
(21) Anmeldenummer: 06777950.4
(22) Anmeldetag: 25.07.2006
(51) Int. Cl.: G01R 31/28

(54) **VERFAHREN ZUM ÜBERPRÜFEN EINER INDUKTIVEN LAST**
METHOD FOR CHECKING AN INDUCTIVE LOAD
PROCEDE DE CONTROLE D'UNE CHARGE INDUCTIVE

(30) Priorität: 04.08.2005 DE 102005036769
(43) Veröffentlichungstag der Anmeldung: 16.04.2008
(73) Patentinhaber: Continental Automotive GmbH, 30165 Hannover (DE)
(72) Erfinder: BERBERICH, Reinhold, 60439 Frankfurt/Main (DE)
(86) Internationale Anmeldenummer: PCT/EP2006/064616
(87) Internationale Veröffentlichungsnummer: WO 2007/014875

(56) Entgegenhaltungen:
- DE-A1- 3 436 776
- US-A- 4 439 806
- US-A- 4 541 389
- US-A- 5 723 958

## Beschreibung

Die Erfindung betrifft ein Verfahren zum Überprüfen einer induktiven Last eines elektromechanischen Wandlers, insbesondere eines Ventils mit elektromagnetischem Aktor, in einer Vollbrückenschaltung oder in einer Halbbrückenschaltung.

An Ventile mit elektromagnetischem Aktor, die beispielsweise in Kraftfahrzeugen genutzt werden, werden hohe Anforderungen bezüglich Sicherheit und Zuverlässigkeit gestellt. Um einen zuverlässigen und sicheren Betrieb des Kraftfahrzeugs sicherstellen zu können, müssen die Ventile elektrisch überprüfbar sein, so dass Fehler, z. B. ein Kurzschluss oder eine Unterbrechung einer Zuleitung, erkannt werden können.

In der DE 34 36 776 A1 ist eine Überwachungseinrichtung für einen kollektorlosen Gleichstrommotor offenbart. Der Gleichstrommotor wird von einer H-Brückenschaltung angesteuert. Mittels einer Ablaufsteuerung wird nach einem vorgegebenen Schema sensiert, ob Endstufe und Stromsensoren funktionsfähig sind. Schalttransistoren der Endstufe werden paarweise angesteuert und durch Sensieren der Wicklungsströme in den Motorwicklungen und eines Summenstroms wird ein Kurzschluss oder eine Unterbrechung festgestellt. Der Überwachungsablauf wird in einer Stillstandsphase des Motors gestartet. Durch eine Feststellvorrichtung wird während des Überwachungsablaufs eine Drehung des Motors verhindert.

Die Aufgabe der Erfindung ist, ein Verfahren zum Überprüfen einer induktiven Last eines elektromechanischen Wandlers in einer Vollbrückenschaltung oder in einer Halbbrückenschaltung zu schaffen, das einfach und zuverlässig ist.

Die Aufgabe wird gelöst durch die Merkmale der unabhängigen Patentansprüche. Vorteilhafte Weiterbildungen der Erfindung sind in den Unteransprüchen gekennzeichnet.

Gemäß einem ersten Aspekt zeichnet sich die Erfindung aus durch ein Verfahren zum Überprüfen einer induktiven Last eines elektromechanischen Wandlers in einer Vollbrückenschaltung. Die Vollbrückenschaltung umfasst ein erstes, zweites, drittes und viertes Schaltelement. Das dritte und das zweite Schaltelement bilden eine erste Reihenschaltung und das erste und das vierte Schaltelement bilden eine zweite Reihenschaltung. Die erste und die zweite Reihenschaltungen sind elektrisch parallel zueinander zwischen einem Versorgungspotenzial und einem Bezugspotenzial angeordnet. Das erste und das dritte Schaltelement sind mit dem Versorgungspotenzial gekoppelt und das zweite und das vierte Schaltelement sind mit dem Bezugspotenzial gekoppelt. Die induktive Last ist mit einem ersten Anschluss elektrisch über einen Messwiderstand mit einem Mittelabgriff der ersten Reihenschaltung gekoppelt und mit einem zweiten Anschluss elektrisch mit einem Mittelabgriff der zweiten Reihenschaltung gekoppelt. Bei dem Verfahren umfasst die Überprüfung mindestens einen Messvorgang. Innerhalb des mindestens einen Messvorgangs wird jeweils entweder nur das zweite oder nur das dritte Schaltelement eingeschaltet oder werden nur das erste und das zweite Schaltelement oder nur das dritte und das vierte Schaltelement eingeschaltet. Zu mindestens einem Erfassungszeitpunkt innerhalb des jeweiligen Messvorgangs wird eine Größe erfasst, die repräsentativ ist für einen elektrischen Strom, der durch den Messwiderstand fließt. Abhängig von der erfassten Größe und dem jeweils eingeschalteten Schaltelement bzw. den jeweils eingeschalteten Schaltelementen wird ein Fehler oder eine Fehlerfreiheit der induktiven Last in der Vollbrückenschaltung erkannt. Eine Zeitdauer für die Überprüfung ist so vorgegeben, dass diese eine Mindestzeitdauer unterschreitet, für die eine Mindeststromstärke durch die induktive Last fließen muss für ein Auslenken des elektromechanischen Wandlers aus seiner Ruhestellung, so dass während dieser Zeitdauer die Ruhestellung des elektromechanischen Wandlers erhalten bleibt.

Die Erfindung beruht auf der Erkenntnis, dass die Ruhestellung des elektromechanischen Wandlers, z. B. ein Ventil mit einem elektromagnetischen Aktor oder ein Elektromotor, verlassen wird, wenn die Mindeststromstärke für die Mindestzeitdauer durch die induktive Last fließt. Das Überprüfen der induktiven Last soll jedoch nicht zu einem Auslenken des elektromechanischen Wandlers aus seiner Ruhestellung führen, damit durch das Überprüfen der induktiven Last keine unerwünschten Auswirkungen durch das Auslenken des elektromechanischen Wandlers entstehen, z. B. Geräuschentwicklung. Die Zeitdauer für die Überprüfung der induktiven Last ist deshalb so vorgegeben, dass diese unterhalb der Mindestzeitdauer bleibt. Ein weiterer Vorteil ist, dass dadurch das Überprüfen der induktiven Last sehr schnell erfolgen kann, z. B. innerhalb weniger Millisekunden.

Die Erfindung beruht ferner auf der Erkenntnis, dass ein Stromanstieg bei einem Stromfluss zwischen dem Versorgungspotenzial und dem Bezugspotenzial, der nur über den Messwiderstand begrenzt wird, größer ist als ein Stromanstieg bei einem Stromfluss, der zusätzlich durch die induktive Last gedrosselt ist. Ferner soll in der Vollbrückenschaltung nur dann ein Strom durch die induktive Last und den Messwiderstand fließen, wenn das erste und das zweite Schaltelement oder das dritte und das vierte Schaltelement eingeschaltet sind.

Ein weiterer Vorteil ist, dass die Vollbrückenschaltung schaltungstechnisch nicht verändert werden muss, um das Verfahren zum Überprüfen der induktiven Last durchführen zu können. Fehler der induktiven Last oder eines Kopplungszustandsder induktiven Last in der Vollbrückenschaltung können so einfach und zuverlässig erkannt werden.

In einer vorteilhaften Ausgestaltung des Verfahrens wird ein Kurzschluss des ersten Anschlusses zu dem Versorgungspotenzial erkannt, wenn nur das zweite Schaltelement eingeschaltet ist und ein Betrag der erfassten Größe größer ist als ein vorgegebener oberer Schwellenwert. Der vorgegebene obere Schwellenwert kann abhängig von dem jeweiligen Erfassungszeitpunkt oder der induktiven Last sein. Der Vorteil ist, dass das Verfahren sehr einfach ist und bei geeigneter Vorgabe des vorgegebenen oberen Schwellenwerts ein zuverlässiges Erkennen des Kurzschlusses des ersten Anschlusses zu dem Versorgungspotenzial ermöglicht.

In einer weiteren vorteilhaften Ausgestaltung des Verfahrens wird ein Kurzschluss des zweiten Anschlusses zu dem Versorgungspotenzial erkannt, wenn nur das zweite Schaltelement eingeschaltet ist und der Betrag der erfassten Größe größer ist als ein vorgegebener unterer Schwellenwert und kleiner ist als der vorgegebene obere Schwellenwert. Der vorgegebene untere Schwellenwert kann ebenso wie der vorgegebene obere Schwellenwert abhängig von dem jeweiligen Erfassungszeitpunkt oder der induktiven Last vorgegeben werden. Der Vorteil ist, dass das Verfahren sehr einfach ist und dass der Kurzschluss des zweiten Anschlusses zu dem Versorgungspotenzial bei geeigneter Vorgabe des vorgegebenen oberen und unteren Schwellenwerts zuverlässig erkannt werden kann.

In einer weiteren vorteilhaften Ausgestaltung des Verfahrens wird ein Kurzschluss des ersten Anschlusses zu dem Bezugspotenzial erkannt, wenn nur das dritte Schaltelement eingeschaltet ist und der Betrag der erfassten Größe größer ist als der vorgegebene obere Schwellenwert. Der Vorteil ist, dass das Verfahren sehr einfach ist und dass der Kurzschluss des ersten Anschlusses zu dem Bezugspotenzial bei geeigneter Vorgabe des vorgegebenen oberen Schwellenwerts zuverlässig erkannt werden kann.

In einer weiteren vorteilhaften Ausgestaltung des Verfahrens wird ein Kurzschluss des zweiten Anschlusses zu dem Bezugspotenzial erkannt, wenn nur das dritte Schaltelement eingeschaltet ist und der Betrag der erfassten Größe größer ist als der vorgegebene untere Schwellenwert und kleiner ist als der vorgegebene obere Schwellenwert. Der Vorteil ist, dass das Verfahren sehr einfach ist und dass der Kurzschluss des zweiten Anschlusses zu dem Bezugspotenzial bei geeigneter Vorgabe des vorgegebenen oberen und unteren Schwellenwerts zuverlässig erkannt werden kann.

In einer weiteren vorteilhaften Ausgestaltung des Verfahrens wird ein Kurzschluss zwischen dem ersten und dem zweiten Anschluss erkannt, wenn nur das erste und das zweite Schaltelement oder nur das dritte und das vierte Schaltelement eingeschaltet sind und der Betrag der erfassten Größe größer ist als der vorgegebene obere Schwellenwert. Der Vorteil ist, dass das Verfahren sehr einfach ist und dass der Kurzschluss zwischen dem ersten und dem zweiten Anschluss bei geeigneter Vorgabe des vorgegebenen oberen Schwellenwerts zuverlässig erkannt werden kann.

In einer weiteren vorteilhaften Ausgestaltung des Verfahrens wird eine Unterbrechung zwischen dem ersten und dem zweiten Anschluss erkannt, wenn nur das erste und das zweite Schaltelement oder nur das dritte und das vierte Schaltelement eingeschaltet sind und der Betrag der erfassten Größe kleiner ist als der vorgegebene untere Schwellenwert. Dies hat den Vorteil, dass das Verfahren sehr einfach ist und dass die Unterbrechung zwischen dem ersten und dem zweiten Anschluss bei geeigneter Vorgabe des vorgegebenen unteren Schwellenwerts zuverlässig erkannt werden kann.

Gemäß einem zweiten Aspekt, zeichnet sich die Erfindung aus, durch ein Verfahren zum Überprüfen einer induktiven Last eines elektromechanischen Wandlers in einer Halbbrückenschaltung. Die Halbbrückenschaltung umfasst ein erstes und ein zweites Schaltelement. Das erste Schaltelement ist mit dem Versorgungspotenzial gekoppelt und das zweite Schaltelement ist mit dem Bezugspotenzial gekoppelt. Die induktive Last ist mit einem ersten Anschluss elektrisch über einen Messwiderstand mit dem zweiten Schaltelement gekoppelt und mit einem zweiten Anschluss elektrisch mit dem ersten Schaltelement gekoppelt. Bei dem Verfahren umfasst die Überprüfung mindestens einen Messvorgang. Innerhalb des mindestens einen Messvorgangs wird jeweils nur das zweite Schaltelement eingeschaltet oder werden das erste und das zweite Schaltelement eingeschaltet. Zu mindestens einem Erfassungszeitpunkt innerhalb des jeweiligen Messvorgangs wird eine Größe erfasst, die repräsentativ ist für einen elektrischen Strom, der durch den Messwiderstand fließt. Abhängig von der erfassten Größe und dem jeweils eingeschalteten Schaltelement bzw. den jeweils eingeschalteten Schaltelementen wird ein Fehler oder eine Fehlerfreiheit der induktiven Last in der Halbbrückenschaltung erkannt. Eine Zeitdauer für die Überprüfung ist so vorgegeben, dass diese eine Mindestzeitdauer unterschreitet, für die eine Mindeststromstärke durch die induktive Last fließen muss für ein Auslenken des elektromechanischen Wandlers aus seiner Ruhestellung, so dass während dieser Zeitdauer eine Ruhestellung des elektromechanischen Wandlers erhalten bleibt. Die Vorteile des Verfahrens entsprechen denen des Verfahrens zum Überprüfen der induktiven Last des elektromechanischen Wandlers in der Vollbrückenschaltung.

In einer vorteilhaften Ausgestaltung des Verfahrens wird ein Kurzschluss des ersten Anschlusses zu dem Versorgungspotenzial erkannt, wenn nur das zweite Schaltelement eingeschaltet ist und ein Betrag der erfassten Größe größer ist als ein vorgegebener oberer Schwellenwert. Der Vorteil ist, dass das Verfahren sehr einfach ist und dass der Kurzschluss des ersten Anschlusses zu dem Versorgungspotenzial bei geeigneter Vorgabe des vorgegebenen oberen Schwellenwerts zuverlässig erkannt werden kann.

In einer weiteren vorteilhaften Ausgestaltung des Verfahrens wird ein Kurzschluss des zweiten Anschlusses zu dem Versorgungspotenzial erkannt, wenn nur das zweite Schaltelement eingeschaltet ist und der Betrag der erfassten Größe größer ist als ein vorgegebener unterer Schwellenwert und kleiner ist als der vorgegebene obere Schwellenwert. Der Vorteil ist, dass das Verfahren sehr einfach ist und dass der Kurzschluss des zweiten Anschlusses zu dem Versorgungspotenzial bei geeigneter Vorgabe des vorgegebenen oberen und unteren Schwellenwerts zuverlässig erkannt werden kann.

In einer weiteren vorteilhaften Ausgestaltung des Verfahrens wird ein Kurzschluss zwischen dem ersten und dem zweiten Anschluss erkannt, wenn das erste und das zweite Schaltelement eingeschaltet sind und der Betrag der erfassten Größe größer ist als der vorgegebene obere Schwellenwert. Der Vorteil ist, dass das Verfahren sehr einfach ist und dass der Kurzschluss zwischen dem ersten und dem zweiten Anschluss bei geeigneter Vorgabe des vorgegebenen oberen Schwellenwerts zuverlässig erkannt werden kann.

In einer weiteren vorteilhaften Ausgestaltung des Verfahrens wird eine Unterbrechung zwischen dem ersten und dem zweiten Anschluss erkannt, wenn das erste und das zweite Schaltelement eingeschaltet sind und der Betrag der erfassten Größe kleiner ist als der vorgegebene untere Schwellenwert. Der Vorteil ist, dass das Verfahren sehr einfach ist und dass die Unterbrechung zwischen dem ersten und dem zweiten Anschluss bei geeigneter Vorgabe des unteren Schwellenwerts zuverlässig erkannt werden kann.

In einer weiteren vorteilhaften Ausgestaltung des Verfahrens umfasst die Halbbrückenschaltung einen Parallelwiderstand, der elektrisch parallel zu der induktiven Last angeordnet ist. Zu dem mindestens einen Erfassungszeitpunkt wird ein Signalpegel des ersten Anschlusses erfasst. Ein Kurzschluss des ersten oder des zweiten Anschlusses zu dem Bezugspotenzial wird erkannt, wenn nur das erste Schaltelement eingeschaltet ist und der erfasste Signalpegel dem Bezugspotenzial entspricht. Der Vorteil ist, dass das Verfahren sehr einfach ist und dass durch eine einfache Erweiterung der Halbbrückenschaltung durch den Parallelwiderstand der Kurzschluss des ersten oder des zweiten Anschlusses zu dem Bezugspotenzial zuverlässig erkannt werden kann.

Ausführungsbeispiele der Erfindung sind im Folgenden anhand der schematischen Zeichnungen erläutert. Es zeigen:
- Figur 1: eine Vollbrückenschaltung,
- Figur 2: ein Strom-Zeit-Diagramm,
- Figur 3: eine Halbbrückenschaltung,
- Figur 4a, b, c: ein Ablaufdiagramm eines Programms zum Überprüfen der induktiven Last eines elektromechanischen Wandlers in der Vollbrückenschaltung und
- Figur 5a, b: ein Ablaufdiagramm eines Programms zum Überprüfen der induktiven Last des elektromechanischen Wandlers in der Halbbrückenschaltung.

Elemente gleicher Konstruktion oder Funktion sind figurenübergreifend mit den gleichen Bezugszeichen versehen.

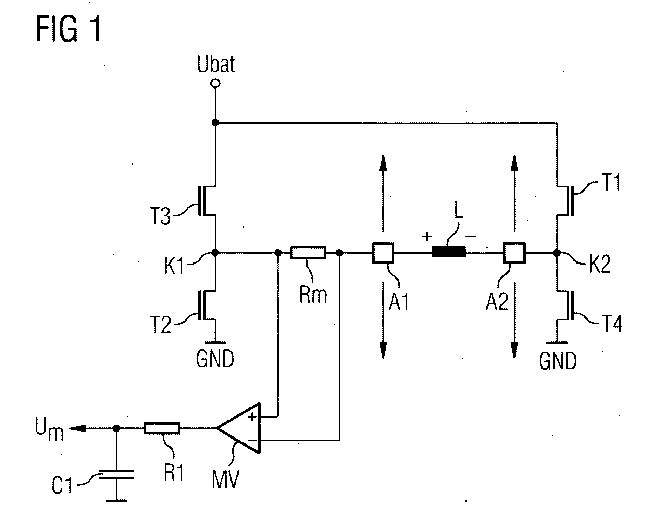

Eine Vollbrückenschaltung umfasst ein erstes, zweites, drittes und viertes Schaltelement T1, T2, T3, T4, die beispielsweise als Transistoren ausgebildet sind und durch eine nicht dargestellte Steuereinheit ansteuerbar sind (Figur 1). Das dritte und das zweite Schaltelement T3, T2 bilden eine erste Reihenschaltung und das erste und das vierte Schaltelement T1, T4 bilden eine zweite Reihenschaltung, die elektrisch zwischen einem Versorgungspotenzial Ubat und einem Bezugspotenzial GND angeordnet sind. Das erste und das dritte Schaltelement T1, T3 sind dazu mit dem Versorgungspotenzial Ubat gekoppelt und das zweite und das vierte Schaltelement T2, T4 sind mit dem Bezugspotenzial GND gekoppelt.

Elektrisch zwischen dem dritten und dem zweiten Schaltelement T3, T2 ist ein Mittelabgriff K1 der ersten Reihenschaltung vorgesehen und elektrisch zwischen dem ersten und dem vierten Schaltelement ist eine Mittelabgriff K2 der zweiten Reihenschaltung vorgesehen. Eine induktive Last L ist mit einem ersten Anschluss A1 über einen Messwiderstand Rm mit dem Mittelabgriff K1 der ersten Reihenschaltung gekoppelt. Die induktive Last L ist ferner über einen zweiten Anschluss A2 mit dem Mittelabgriff K2 der zweiten Reihenschaltung gekoppelt.

Über den Messwiderstand Rm wird eine Messspannung abgegriffen und durch einen Messverstärker MV verstärkt. Die verstärkte Messspannung kann durch ein RC-Glied, das durch einen ersten Widerstand R1 und einen ersten Kondensator C1 gebildet ist, geglättet werden und z. B. der Steuereinheit zugeführt werden. Die Steuereinheit ist beispielsweise ausgebildet, abhängig von der Messspannung Um das erste, zweite, dritte oder vierte Schaltelement T1, T2, T3, T4 zum Betreiben der induktiven Last geeignet anzusteuern. Die Messspannung Um ist beispielsweise eine Größe, die repräsentativ ist für einen elektrischen Strom I, der durch den Messwiderstand Rm fließt.

Die induktive Last L ist beispielsweise durch einen elektromechanischen Wandler gebildet, z. B. durch ein Ventil mit einem elektromagnetischen Aktor oder einem Elektromotor. Ein solcher elektromechanischer Wandler weist beispielsweise einen Anker auf, der bei geeignetem Bestromen der induktiven Last L aus einer Ruhestellung ausgelenkt werden kann, z. B. zum Öffnen oder Schließen des Ventils oder zum Drehen des Rotors des Elektromotors. Für das Auslenken des Ankers aus der Ruhestellung muss durch die induktive Last eine Mindeststromstärke für eine Mindestzeitdauer fließen, um ein magnetisches Feld ausreichender Stärke zu erzeugen. Beispielsweise beträgt die Mindestzeitdauer etwa 30 Millisekunden.

Bei einem Überprüfen der induktiven Last L in der Vollbrückenschaltung soll der Anker jedoch in seiner Ruhestellung verbleiben, um unerwünschte Auswirkungen, die durch das Auslenken des elektromechanischen Wandlers aus der Ruhestellung verursacht werden können, zu verhindern. Dazu werden das erste, das zweite, das dritte oder das vierte Schaltelement T1, T2, T3, T4 nur kurzzeitig, z. B. für wenige Millisekunden, eingeschaltet, um Messungen zu ermöglichen. Das Überprüfen der induktiven Last L in der Vollbrückenschaltung muss beendet sein, bevor der elektrische Strom I durch die induktive Last L so groß geworden ist, dass der elektromechanische Wandler aus seiner Ruhestellung ausgelenkt wird.

Das Überprüfen der induktiven Last L in der Vollbrückenschaltung kann beispielsweise in ein oder mehrere Messvorgänge unterteilt werden, die in schneller Folge nacheinander oder in größerem zeitlichen Abstand voneinander durchgeführt werden. Eine Zeitdauer für die Überprüfung ist dabei so vorgegeben, dass während dieser Zeitdauer die Ruhestellung des elektromechanischen Wandlers erhalten bleibt. Beispielsweise beträgt die Zeitdauer für die Überprüfung maximal 10 bis 20 Millisekunden.

Innerhalb des jeweiligen Messvorgangs wird zu mindestens einem Erfassungszeitpunkt die Messspannung Um erfasst. Abhängig von der Messspannung Um in dem in dem jeweiligen Messvorgang eingeschalteten Schaltelement wird ein Fehler oder eine Fehlerfreiheit der induktiven Last in der Vollbrückenschaltung erkannt. Fehler sind beispielsweise ein Kurzschluss des ersten oder des zweiten Anschlusses A1, A2 zu dem Versorgungspotenzial Ubat oder zu dem Bezugspotenzial GND oder ein Kurzschluss oder eine Unterbrechung zwischen dem ersten und dem zweiten Anschluss A1, A2.

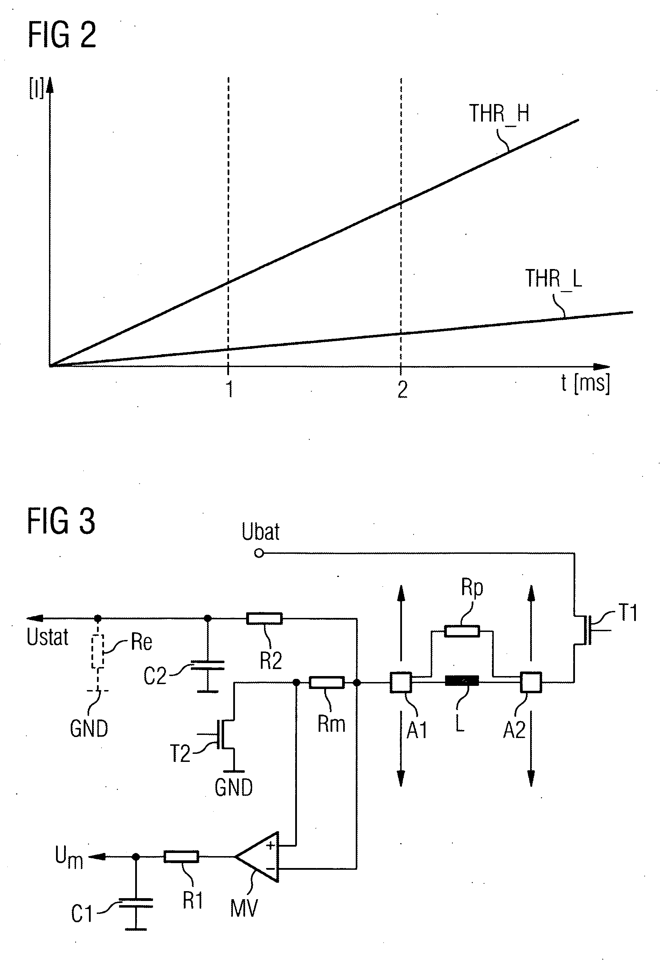

Ein Kurzschluss des ersten Anschlusses A1 zu dem Versorgungspotenzial Ubat kann erkannt werden durch Einschalten nur des zweiten Schaltelements T2 und durch Erfassen der Messspannung Um zu dem mindestens einen Erfassungszeitpunkt, der beispielsweise eine Millisekunde nach dem Einschalten des zweiten Schaltelements T2 liegt. Der Kurzschluss verursacht einen großen Stromfluss durch den Messwiderstand Rm und somit eine betragsmäßig große Messspannung Um. Insbesondere wird der elektrische Strom I durch den Messwiderstand Rm nicht durch die induktive Last L gedrosselt. Der Kurzschluss kann deshalb sehr einfach erkannt werden, wenn ein Betrag des elektrischen Stroms I bzw. der diesen repräsentierenden Messspannung Um größer ist als ein vorgegebener oberer Schwellenwert THR_H (Figur 2). Der vorgegebene obere Schwellenwert THR_H ist bevorzugt abhängig von dem jeweiligen Erfassungszeitpunkt vorgegeben. Dadurch kann sichergestellt werden, dass der vorgegebene obere Schwellenwert THR_H nur dann überschritten wird, wenn der elektrische Strom I nicht durch die induktive Last L gedrosselt wird. Dazu steigt der vorgegebene obere Schwellenwert THR_H bevorzugt jeweils ab dem Einschalten des zweiten Schaltelements T2 auch dann entsprechend dem elektrischen Strom I, der durch die induktive Last L gedrosselt wird, auch wenn der elektrische Strom I aktuell nicht durch die induktive Last L gedrosselt wird.

Ein Kurzschluss des zweiten Anschlusses A2 zu dem Versorgungspotenzial Ubat kann erkannt werden durch Einschalten nur des zweiten Schaltelements T2 und durch Erfassen der Messspannung Um zu dem mindestens einen Erfassungszeitpunkt. Der elektrische Strom I, der durch den Messwiderstand Rm fließt, ist dann gedrosselt durch die induktive Last L, so dass ein Anstieg des Betrags des elektrischen Stroms I abhängig von der induktiven Last L langsamer verläuft als bei dem Kurzschluss des ersten Anschlusses A1 zu dem Versorgungspotenzial Ubat. Der Kurzschluss des zweiten Anschlusses A2 zu dem Versorgungspotenzial Ubat kann sehr einfach erkannt werden, wenn der Betrag des elektrischen Stroms I bzw. der diesen repräsentierenden Messspannung Um kleiner ist als der vorgegebene obere Schwellenwert THR_H und größer ist als ein vorgegebener unterer Schwellenwert THR_L. Auch der vorgegebene untere Schwellenwert THR_L kann abhängig von dem jeweiligen Erfassungszeitpunkt vorgegeben sein.

Liegt jedoch weder der Kurzschluss des ersten Anschlusses A1 oder des zweiten Anschlusses A2 zu dem Versorgungspotenzial Ubat vor, dann bleibt der Betrag des elektrischen Stroms I kleiner als der vorgegebene untere Schwellenwert THR_L.

Entsprechend kann geprüft werden, ob ein Kurzschluss des ersten Anschlusses A1 oder des zweiten Anschlusses A2 zu dem Bezugspotenzial GND vorliegt. Dazu wird nur das dritte Schaltelement T3 eingeschaltet und die Messspannung Um zu dem mindestens einen Erfassungszeitpunkt erfasst. Der Kurzschluss des ersten Anschlusses A1 zu dem Bezugspotenzial GND wird erkannt, wenn der Betrag des elektrischen Stroms I bzw. der diesen repräsentierenden Messspannung Um den vorgegebenen oberen Schwellenwerts THR_H übersteigt. Der Kurzschluss des zweiten Anschlusses A2 zu dem Bezugspotenzial GND wird erkannt, wenn der Betrag des elektrischen Stroms I bzw. der diesen repräsentierenden Messspannung Um kleiner ist als der vorgegebene obere Schwellenwert THR_H und größer ist als der vorgegebene untere Schwellenwert THR_L. Der Kurzschluss des ersten Anschlusses A1 oder des zweiten Anschlusses A2 zu dem Bezugspotenzial GND liegt jedoch nicht vor, wenn der Betrag des elektrischen Stroms I bzw. der diesen repräsentierenden Messspannung Um kleiner ist als der vorgegebene untere Schwellenwert THR_L.

Für das Erkennen des Kurzschlusses zwischen dem ersten und dem zweiten Anschluss A1, A2 oder der Unterbrechung zwischen dem ersten und dem zweiten Anschluss A1, A2 werden entweder nur das erste und das zweite Schaltelement T1, T2 oder nur das dritte und das vierte Schaltelement T3, T4 eingeschaltet. Bei dem Kurzschluss zwischen dem ersten und dem zweiten Anschluss A1, A2 ist der elektrische Strom I durch den Messwiderstand Rm nicht durch die induktive Last L gedrosselt. Entsprechend wird dieser Kurzschluss erkannt, wenn der Betrag des elektrischen Stroms I bzw. der diesen repräsentierenden Messspannung Um größer ist als der vorgegebene obere Schwellenwert THR_H. Die Unterbrechung zwischen dem ersten und dem zweiten Anschluss A1, A2 wird erkannt, wenn der Betrag des elektrischen Stroms I bzw. der diesen repräsentierenden Messspannung Um kleiner ist als der vorgegebene untere Schwellenwert THR_L. Der Kurzschluss oder die Unterbrechung zwischen dem ersten und dem zweiten Anschluss A1, A2 liegt jedoch nicht vor, wenn der Betrag des elektrischen Stroms I bzw. der diesen repräsentierenden Messspannung Um kleiner ist als der vorgegebene obere Schwellenwert THR_H und größer ist als der vorgegebene untere Schwellenwert THR_L.

Die Fehlerfreiheit der induktiven Last L in der Vollbrückenschaltung wird erkannt, wenn weder der Kurzschluss des ersten Anschluss A1 zu dem Versorgungspotenzial Ubat oder zu dem Bezugspotenzial GND, des zweiten Anschlusses A2 zu dem Versorgungspotenzial Ubat oder zu dem Bezugspotenzial GND, noch der Kurzschluss oder die Unterbrechung zwischen dem ersten und dem zweiten Anschluss A1, A2 erkannt wird.

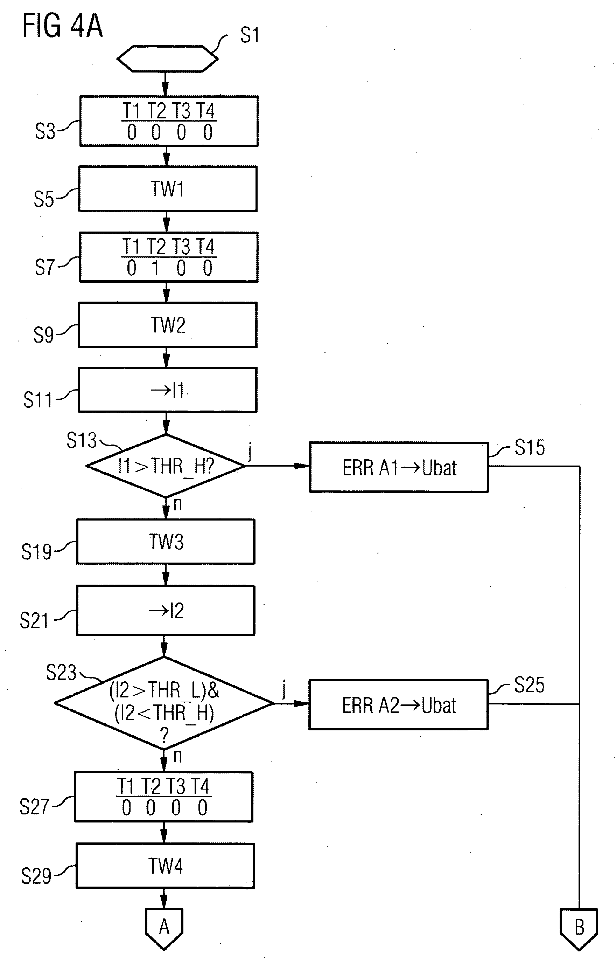

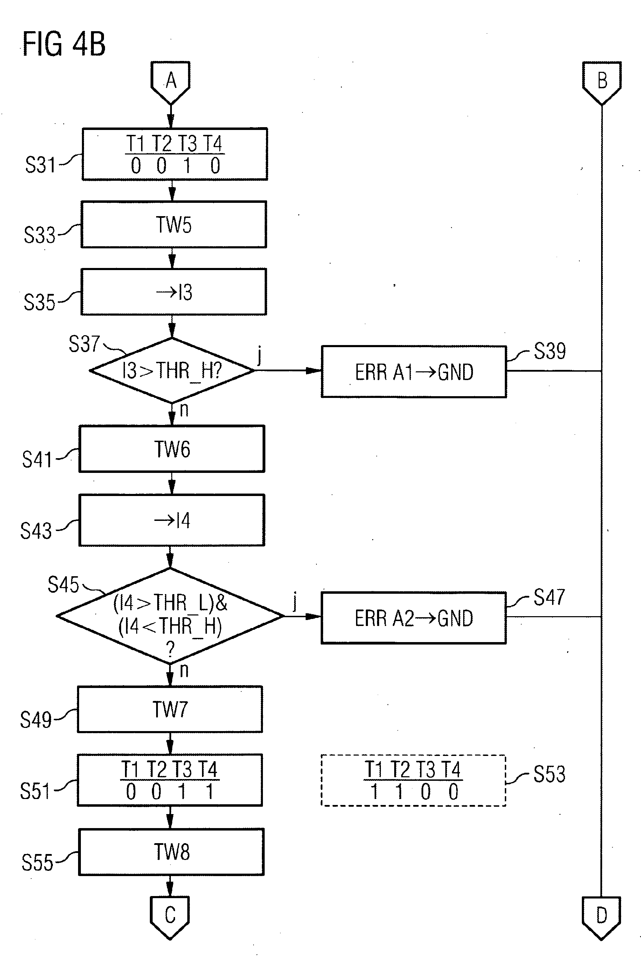

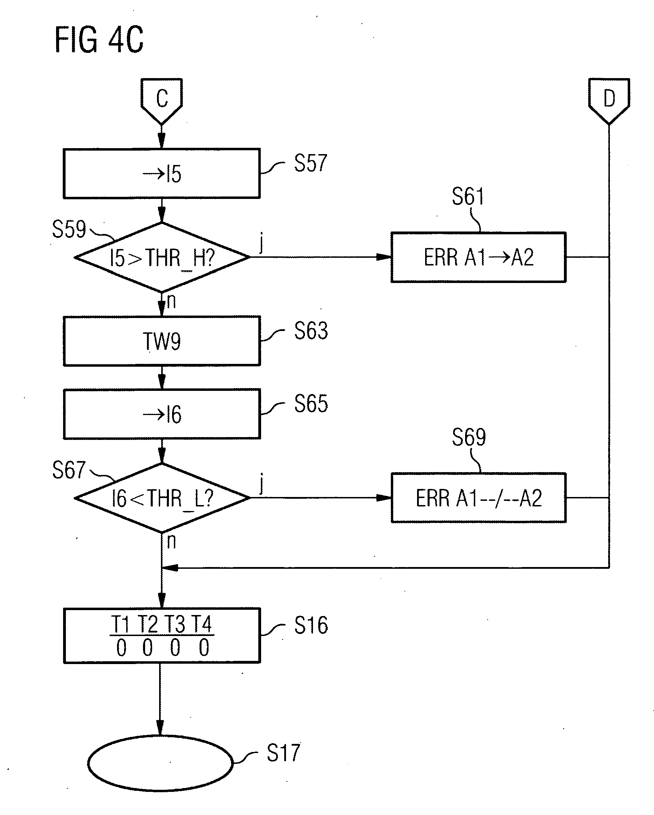

In den Figuren 4a, 4b und 4c ist ein Ablaufdiagramm eines ersten Programms dargestellt, das beispielsweise von der Steuereinheit ausgeführt wird. Das erste Programm umfasst Schritte eines Verfahrens zum Überprüfen der induktiven Last des elektromechanischen Wandlers in der Vollbrückenschaltung. Das erste Programm beginnt mit einem Schritt S1. In einem Schritt S3 werden das erste, das zweite, das dritte und das vierte Schaltelement T1, T2, T3, T4 ausgeschaltet. In einem Schritt S5 wird für eine erste Wartezeitdauer TW1 gewartet. Die Wartezeitdauer TW1 ist vorzugsweise so gewählt, dass ein gegebenenfalls vorhandenes magnetisches Feld der induktiven Last im Wesentlichen vollständig abgebaut wird. Die erste Wartezeitdauer TW1 ist abhängig von der induktiven Last L und beträgt beispielsweise etwa 50 Millisekunden.

In einem Schritt S7 wird das zweite Schaltelement T2 eingeschaltet. In einem Schritt S9 wird für eine zweite Wartezeitdauer TW2 gewartet. In einem Schritt S11 wird ein erster Strom I1 erfasst, der durch den Messwiderstand Rm fließt. Der erste Strom I1 kann auch durch die entsprechende Messspannung Um oder durch eine andere Größe, die repräsentativ ist für den elektrischen Strom I, der durch den Messwiderstand Rm fließt, repräsentiert sein.

In einem Schritt S13 wird überprüft, ob der erste Strom I1 größer ist als der vorgegebene obere Schwellenwert THR_H. Ist die Bedingung erfüllt, dann wird in einem Schritt S15 als Fehler der Kurzschluss des ersten Anschlusses A1 zu dem Versorgungspotenzial Ubat erkannt und das erste Programm wird in einem Schritt S16 fortgeführt. In dem Schritt S16 werden das erste, das zweite, das dritte und das vierte Schaltelement T1, T2, T3, T4 ausgeschaltet. Das erste Programm wird in einem Schritt S17 beendet.

Ist die Bedingung in dem Schritt S13 jedoch nicht erfüllt, dann wird in einem Schritt S19 für eine dritte Wartezeitdauer TW3 gewartet. In einem Schritt S21 wird ein zweiter Strom I2 erfasst. In einem Schritt S23 wird überprüft, ob der zweite Strom I2 größer ist als der vorgegebene untere Schwellenwert THR_L und kleiner ist als der vorgegebene obere Schwellenwert THR_H. Ist die Bedingung erfüllt, dann wird in einem Schritt S25 als Fehler der Kurzschluss des zweiten Anschlusses A2 zu dem Versorgungspotenzial Ubat erkannt und das erste Programm wird in dem Schritt S16 fortgeführt und in dem Schritt S17 beendet.

Ist die Bedingung in dem Schritt S23 nicht erfüllt, dann wird in einem Schritt S27 das erste, das zweite, das dritte und das vierte Schaltelement T1, T2, T3, T4 ausgeschaltet und in einem Schritt S29 für eine vierte Wartezeitdauer TW4 gewartet. In einem Schritt S31 wird das dritte Schaltelement T3 eingeschaltet. In einem Schritt S33 wird für eine fünfte Wartezeitdauer TW5 gewartet und in einem Schritt S35 wird ein dritter Strom I3 erfasst. In einem Schritt S37 wird überprüft, ob der dritte Strom I3 größer ist als der vorgegebene obere Schwellenwert THR_H. Ist die Bedingung erfüllt, dann wird in einem Schritt S39 als Fehler der Kurzschluss des ersten Anschlusses A1 zu dem Bezugspotenzial GND erkannt und das erste Programm wird in dem Schritt S16 fortgeführt und in dem Schritt S17 beendet.

Ist die Bedingung in dem Schritt S37 jedoch nicht erfüllt, dann wird in einem Schritt S41 für eine sechste Wartezeitdauer TW6 gewartet und in einem Schritt S43 wird ein vierter Strom I4 erfasst. In einem Schritt S45 wird überprüft, ob der vierte Strom I4 größer ist als der vorgegebene untere Schwellenwert THR_L und kleiner ist als der vorgegebene obere Schwellenwert THR_H. Ist die Bedingung erfüllt, dann wird in einem Schritt S47 als Fehler der Kurzschluss des zweiten Anschlusses A2 zu dem Bezugspotenzial GND erkannt und das erste Programm wird in dem Schritt S16 fortgeführt und in dem Schritt S17 beendet.

Ist die Bedingung in dem Schritt S45 jedoch nicht erfüllt, dann wird in einem Schritt S49 für eine siebte Wartezeitdauer TW7 gewartet. In einem Schritt S51 werden das dritte und das vierte Schaltelement T3, T4 eingeschaltet. Alternativ zu dem Schritt S51 kann in einem Schritt S53 das erste und das zweite Schaltelement T1, T2 eingeschaltet werden. In einem Schritt S55 wird für eine achte Wartezeitdauer TW8 gewartet. In einem Schritt S57 wird ein fünfter Strom I5 erfasst. In einem Schritt S59 wird überprüft, ob der fünfte Strom I5 größer ist als der vorgegebene obere Schwellenwert THR_H. Ist die Bedingung erfüllt, dann wird in einem Schritt S61 als Fehler der Kurzschluss zwischen dem ersten und dem zweiten Anschluss A1, A2 erkannt und das erste Programm wird in dem Schritt S16 fortgeführt und in dem Schritt S17 beendet.

Ist die Bedingung in dem Schritt S59 jedoch nicht erfüllt, dann wird in einem Schritt S63 für eine neunte Wartezeitdauer TW9 gewartet und in einem Schritt S65 ein sechster Strom I6 erfasst. In einem Schritt S67 wird überprüft, ob der sechste Strom I6 kleiner ist als der vorgegebene untere Schwellenwert THR_L. Ist die Bedingung erfüllt, dann wird in einem Schritt S69 als Fehler die Unterbrechung zwischen dem ersten und dem zweiten Anschluss A1, A2 erkannt und das erste Programm wird in dem Schritt S16 fortgeführt und in dem Schritt S17 beendet. Ist die Bedingung in dem Schritt S67 jedoch nicht erfüllt, dann wird die Fehlerfreiheit erkannt und das erste Programm wird nach dem Ausführen des Schritts S16 in dem Schritt S17 beendet. Bei erkannter Fehlerfreiheit kann der elektromechanische Wandler auch entsprechend einem gewünschten Betrieb angesteuert werden, ohne dass zuvor der Schritt S16 ausgeführt wird.

Eine entsprechende Überprüfung der induktiven Last L des elektromechanischen Wandlers kann auch durchgeführt werden, wenn die induktive Last L in einer Halbbrückenschaltung betrieben wird (Figur 3). Zwischen dem Versorgungspotenzial Ubat und dem Bezugspotenzial GND ist elektrisch eine Reihenschaltung aus dem ersten Schaltelement T1, der induktiven Last L, des Messwiderstands Rm und dem zweiten Schaltelement T2 angeordnet. Ferner umfasst die Halbbrückenschaltung einen Parallelwiderstand Rp, der elektrisch parallel zu der induktiven Last angeordnet ist. Ein Signalpegel des ersten Anschlusses A1 kann als Statusspannung Ustat über ein weiteres RC-Glied, das einen zweiten Widerstand R2 und einen zweiten Kondensator C2 umfasst, der Steuereinheit zugeführt werden. Die Statusspannung Ustat wird durch einen Eingangswiderstand Re, der z. B. in der Steuereinheit angeordnet ist, auf dem Bezugspotenzial GND gehalten, solange dem ersten Anschluss A1 kein anderes Potenzial zugewiesen wird.

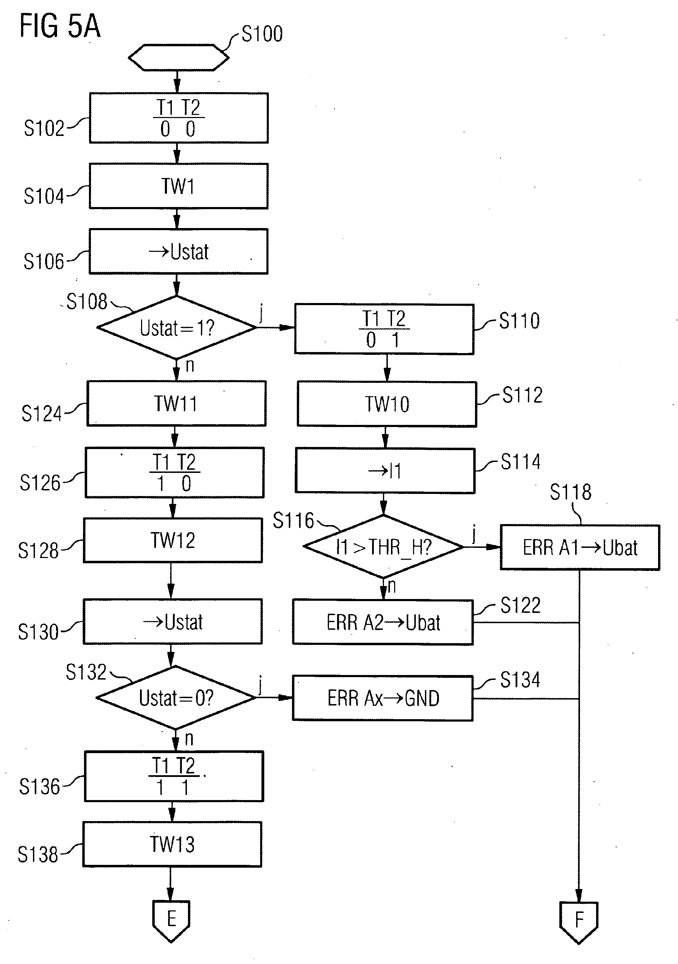

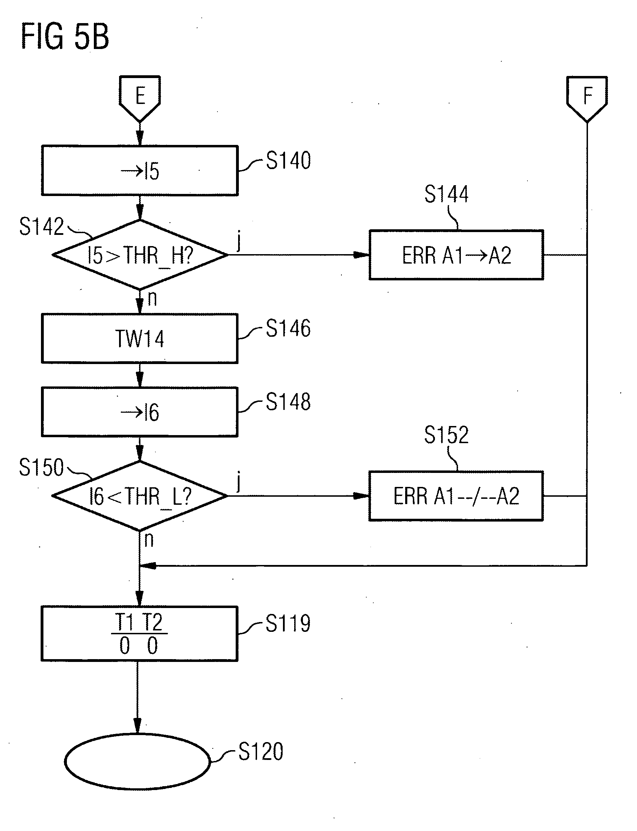

In den Figuren 5a und 5b ist ein Ablaufdiagramm eines zweiten Programms dargestellt, das beispielsweise von der Steuereinheit ausgeführt wird. Das zweite Programm umfasst Schritte eines Verfahrens zum Überprüfen der induktiven Last des elektromechanischen Wandlers in der Halbbrückenschaltung. Das zweite Programm beginnt mit einem Schritt S100. In einem Schritt S102 werden das erste und das zweite Schaltelement T1, T2 ausgeschaltet. In einem Schritt S104 wird für die erste Wartezeitdauer TW1 gewartet.

In einem Schritt S106 wird die Statusspannung Ustat erfasst. In einem Schritt S108 wird überprüft, ob die Statusspannung einen High-Pegel aufweist, also etwa dem Versorgungspotenzial Ubat entspricht. Ist die Bedingung erfüllt, dann wird in einem Schritt S110 das zweite Schaltelement T2 eingeschaltet. In einem Schritt S112 wird für eine zehnte Wartezeitdauer TW10 gewartet. In einem Schritt S114 wird der erste Strom I1 erfasst. In einem Schritt S116 wird überprüft, ob der erste Strom I1 größer ist als der vorgegebene obere Schwellenwert THR_H. Ist die Bedingung erfüllt, dann wird in einem Schritt S118 als Fehler der Kurzschluss des ersten Anschlusses A1 zu dem Versorgungspotenzial Ubat erkannt und das zweite Programm wird in einem Schritt S119 fortgeführt. In dem Schritt S119 werden das erste und das zweite Schaltelement T1, T2 ausgeschaltet. Das zweite Programm wird in einem Schritt S120 beendet. Ist die Bedingung in dem Schritt S116 jedoch nicht erfüllt, dann wird in einem Schritt S122 als Fehler der Kurzschluss des zweiten Anschlusses A2 zu dem Versorgungspotenzial Ubat erkannt und das zweite Programm in dem Schritt S119 fortgeführt und in dem Schritt S120 beendet.

Ist die Bedingung in dem Schritt S108 jedoch nicht erfüllt, das heißt, die Statusspannung Ustat weist einen Low-Pegel auf, entspricht also etwa dem Bezugspotenzial GND, dann wird in einem Schritt S124 für eine elfte Wartezeitdauer TW11 gewartet. In einem Schritt S126 wird das erste Schaltelement T1 eingeschaltet. In einem Schritt S128 wird für eine zwölfte Wartezeitdauer TW12 gewartet und in einem Schritt S130 wird die Statusspannung Ustat erfasst. In einem Schritt S132 wird überprüft, ob die Statusspannung den Low-Pegel aufweist. Ist diese Bedingung erfüllt, dann wird in einem Schritt S134 als Fehler der Kurzschluss des ersten oder des zweiten Anschlusses A1, A2 zu dem Bezugspotenzial GND erkannt und das zweite Programm wird in dem Schritt S119 fortgeführt und in dem Schritt S120 beendet.

Ist die Bedingung in dem Schritt S132 jedoch nicht erfüllt, dann wird in einem Schritt S136 das erste und das zweite Schaltelement T1, T2 eingeschaltet und in einem Schritt S138 wird für eine dreizehnte Wartezeitdauer Tw13 gewartet. In einem Schritt S140 wird der fünfte Strom I5 erfasst. In einem Schritt S142 wird überprüft, ob der fünfte Strom I5 größer ist als der vorgegebene obere Schwellenwert THR_H. Ist diese Bedingung erfüllt, dann wird in einem Schritt S144 als Fehler der Kurzschluss zwischen dem ersten und dem zweiten Anschluss A1, A2 erkannt.und das zweite Programm wird in dem Schritt S119 fortgeführt und in dem Schritt S120 beendet.

Ist die Bedingung in dem Schritt S142 jedoch nicht erfüllt, dann wird in einem Schritt S146 für eine vierzehnte Wartezeitdauer TW14 gewartet und in einem Schritt S148 der sechste Strom I6 erfasst. In einem Schritt S150 wird überprüft, ob der sechste Strom 16 kleiner ist als der vorgegebene untere Schwellenwert THR_L. Ist die Bedingung erfüllt, dann wird in einem Schritt S152 als Fehler die Unterbrechung zwischen dem ersten und dem zweiten Anschluss A1, A2 erkannt und das zweite Programm wird in dem Schritt S119 fortgeführt und in dem Schritt S120 beendet. Ist die Bedingung in dem Schritt S150 jedoch nicht erfüllt, dann wird die Fehlerfreiheit erkannt und das zweite Programm wird nach dem Ausführen des Schritts S119 in dem Schritt S120 beendet. Bei erkannter Fehlerfreiheit kann der elektromechanische Wandler auch entsprechend einem gewünschten Betrieb angesteuert werden, ohne dass zuvor der Schritt S119 ausgeführt wird.

Der Parallelwiderstand Rp ermöglicht eine Unterscheidung zwischen dem Kurzschluss des ersten oder des zweiten Anschlusses A1, A2 zu dem Bezugspotenzial und der Unterbrechung zwischen dem ersten und dem zweiten Anschluss A1, A2. Der Parallelwiderstand Rp ermöglicht einen High-Pegel der Statusspannung Ustat auch dann, wenn die Unterbrechung zwischen dem ersten und dem zweiten Anschluss A1, A2 vorliegt. Die Statusspannung Ustat weist in dem Schritt S130 somit nur dann einen Low-Pegel auf, wenn der Kurzschluss des ersten oder des zweiten Anschlusses A1, A2 zu dem Bezugspotenzial vorliegt. Alternativ zu dem Parallelwiderstand Rp und dem Abgriff der Statusspannung Ustat an dem ersten Anschluss A1 kann auch ein weiterer Messwiderstand elektrisch zwischen dem zweiten Anschluss A2 und dem ersten Schaltelement T1 angeordnet sein und eine weitere Messspannung erfasst werden, die repräsentativ ist für den elektrischen Strom I, der durch den weiteren Messwiderstand fließt. Dann kann auch durch Einschalten nur des ersten Schaltelements T1 und durch Erfassen der weiteren Messspannung der Kurzschluss des ersten oder des zweiten Anschusses A1, A2 zu dem Bezugspotenzial GND entsprechend zu dem Verfahren zum Überprüfen der induktiven Last des elektromechanischen Wandlers in der Vollbrückenschaltung erkannt werden.

Die zweite bis vierzehnte Wartezeitdauer TW2-TW14 beträgt jeweils beispielsweise etwa eine Millisekunde. Diese Wartezeitdauern können jedoch auch kürzer oder länger oder unterschiedlich gewählt werden. Insbesondere können die zweite bis vierzehnte Wartezeitdauer TW2-TW14 abhängig von der induktiven Last L oder abhängig von einer Dimensionierung des ersten Widerstands R1 und des ersten Kondensators C1 oder des zweiten Widerstands R2 und des zweiten Kondensators C2 gewählt werden, damit der erste bis sechste Strom I1-I6 oder die Statusspannung Ustat zuverlässig erfasst werden können. Ferner ist eine Summe der zweiten bis neunten Wartezeitdauer TW2-TW9 und eine Summe der zehnten bis vierzehnten Wartezeitdauer TW10-TW14 dadurch begrenzt, dass der elektromechanische Wandler während der Überprüfung seine Ruhestellung beibehalten soll.

## Patentansprüche

1. Verfahren zum Überprüfen einer induktiven Last (L) eines elektromechanischen Wandlers in einer Vollbrückenschaltung, die ein erstes, zweites, drittes und viertes Schaltelement (T1, T2, T3, T4) umfasst und das dritte und das zweite Schaltelement (T3, T2) eine erste Reihenschaltung bilden und das erste und das vierte Schaltelement (T1, T4) eine zweite Reihenschaltung bilden und die erste und die zweite Reihenschaltung elektrisch parallel zueinander zwischen einem Versorgungspotenzial (Ubat) und einem Bezugspotenzial (GND) angeordnet sind, wobei das erste und das dritte Schaltelement (T1, T3) mit dem Versorgungspotenzial (Ubat) gekoppelt sind und das zweite und das vierte Schaltelement (T2, T4) mit dem Bezugspotenzial (GND) gekoppelt sind, und die induktive Last (L) mit einem ersten Anschluss (A1) elektrisch über einen Messwiderstand (Rm) mit einem Mittelabgriff (K1) der ersten Reihenschaltung gekoppelt ist und mit einem zweiten Anschluss (A2) elektrisch mit einem Mittelabgriff (K2) der zweiten Reihenschaltung gekoppelt ist, und bei dem Verfahren
- die Überprüfung mindestens einen Messvorgang umfasst;
- innerhalb des mindestens einen Messvorgangs jeweils entweder nur das zweite oder nur das dritte Schaltelement (T2, T3) eingeschaltet wird oder nur das erste und das zweite Schaltelement (T1, T2) oder nur das dritte und das vierte Schaltelement (T3, T4) eingeschaltet werden,
- zu mindestens einem Erfassungszeitpunkt innerhalb des jeweiligen Messvorgangs eine Größe erfasst wird, die repräsentativ ist für einen elektrischen Strom (I), der durch den Messwiderstand (Rm) fließt,
- abhängig von der erfassten Größe und dem jeweils eingeschalteten Schaltelement bzw. den jeweils eingeschalteten Schaltelementen ein Fehler oder eine Fehlerfreiheit der induktiven Last (L) in der Vollbrückenschaltung erkannt wird, und
- eine Zeitdauer für die Überprüfung so vorgegeben ist, dass diese eine Mindestzeitdauer unterschreitet, für die eine Mindeststromstärke durch die induktive Last (L) fließen muss für ein Auslenken des elektromechanischen Wandlers aus seiner Ruhestellung, so dass innerhalb dieser Zeitdauer die Ruhestellung des elektromechanischen Wandlers erhalten bleibt.

2. Verfahren nach Anspruch 1, bei dem ein Kurzschluss des ersten Anschlusses (A1) zu dem Versorgungspotenzial (Ubat) erkannt wird, wenn nur das zweite Schaltelement (T2) eingeschaltet ist und ein Betrag der erfassten Größe größer ist als ein vorgegebener oberer Schwellenwert (THR_H).

3. Verfahren nach einem der vorstehenden Ansprüche, bei dem ein Kurzschluss des zweiten Anschlusses (A2) zu dem Versorgungspotenzial (Ubat) erkannt wird, wenn nur das zweite Schaltelement (T2) eingeschaltet ist und der Betrag der erfassten Größe größer ist als ein vorgegebener unterer Schwellenwert (THR_L) und kleiner ist als der vorgegebene obere Schwellenwert (THR_H).

4. Verfahren nach einem der vorstehenden Ansprüche, bei dem ein Kurzschluss des ersten Anschlusses (A1) zu dem Bezugspotenzial (GND) erkannt wird, wenn nur das dritte Schaltelement (T3) eingeschaltet ist und der Betrag der erfassten Größe größer ist als der vorgegebene obere Schwellenwert (THR_H).

5. Verfahren nach einem der vorstehenden Ansprüche, bei dem ein Kurzschluss des zweiten Anschlusses (A2) zu dem Bezugspotenzial (GND) erkannt wird, wenn nur das dritte Schaltelement (T3) eingeschaltet ist und der Betrag der erfassten Größe größer ist als der vorgegebene untere Schwellenwert (THR_L) und kleiner ist als der vorgegebene obere Schwellenwert (THR_H).

6. Verfahren nach einem der vorstehenden Ansprüche, bei dem ein Kurzschluss zwischen dem ersten und dem zweiten Anschluss (A1, A2) erkannt wird, wenn nur das erste und das zweite Schaltelement (T1, T2) oder nur das dritte und das vierte Schaltelement (T3, T4) eingeschaltet sind und der Betrag der erfassten Größe größer ist als der vorgegebene obere Schwellenwert (THR_H).

7. Verfahren nach einem der vorstehenden Ansprüche, bei dem eine Unterbrechung zwischen dem ersten und dem zweiten Anschluss (A1, A2) erkannt wird, wenn nur das erste und das zweite Schaltelement (T1, T2) oder nur das dritte und das vierte Schaltelement eingeschaltet sind und der Betrag der erfassten Größe kleiner ist als der vorgegebene untere Schwellenwert (THR_L).

8. Verfahren zum Überprüfen einer induktiven Last (L) eines elektromechanischen Wandlers in einer Halbbrückenschaltung, die ein erstes und ein zweites Schaltelement (T1, T2) umfasst, wobei das erste Schaltelement (T1) mit dem Versorgungspotenzial (Ubat) gekoppelt ist und das zweite Schaltelement (T2) mit dem Bezugspotenzial (GND) gekoppelt ist, und die induktive Last (L) mit einem ersten Anschluss (A1) elektrisch über einen Messwiderstand (Rm) mit dem zweiten Schaltelement (T2) gekoppelt ist und mit einem zweiten Anschluss (A2) elektrisch mit dem ersten Schaltelement (T1) gekoppelt ist, und bei dem Verfahren
- die Überprüfung mindestens einen Messvorgang umfasst,
- innerhalb des mindestens einen Messvorgangs jeweils nur das zweite Schaltelement (T2) eingeschaltet wird oder das erste und das zweite Schaltelement (T1, T2) eingeschaltet werden,
- zu mindestens einem Erfassungszeitpunkt innerhalb des jeweiligen Messvorgangs eine Größe erfasst wird, die repräsentativ ist für einen elektrischen Strom (I), der durch den Messwiderstand (Rm) fließt,
- abhängig von der erfassten Größe und dem jeweils eingeschalteten Schaltelement bzw. den jeweils eingeschalteten Schaltelementen ein Fehler oder eine Fehlerfreiheit der induktiven Last (L) in der Halbbrückenschaltung erkannt wird, und
- eine Zeitdauer für die Überprüfung so vorgegeben ist, dass diese eine Mindestzeitdauer unterschreitet, für die eine Mindeststromstärke durch die induktive Last (L) fließen muss für ein Auslenken des elektromechanischen Wandlers aus seiner Ruhestellung, so dass innerhalb dieser Zeitdauer die Ruhestellung des elektromechanischen Wandlers erhalten bleibt.

9. Verfahren nach Anspruch 8, bei dem ein Kurzschluss des ersten Anschlusses (A1) zu dem Versorgungspotenzial (Ubat) erkannt wird, wenn nur das zweite Schaltelement (T2) eingeschaltet ist und ein Betrag der erfassten Größe größer ist als ein vorgegebener oberer Schwellenwert (THR_H).

10. Verfahren nach einem der Ansprüche 8 oder 9, bei dem ein Kurzschluss des zweiten Anschlusses (A2) zu dem Versorgungspotenzial (Ubat) erkannt wird, wenn nur das zweite Schaltelement (T2) eingeschaltet ist und der Betrag der erfassten Größe größer ist als ein vorgegebener unterer Schwellenwert (THR_L) und kleiner ist als der vorgegebene obere Schwellenwert (THR_H).

11. Verfahren nach einem der Ansprüche 8 bis 10, bei dem ein Kurzschluss zwischen dem ersten und dem zweiten Anschluss (A1, A2) erkannt wird, wenn das erste und das zweite Schaltelement (T1, T2) eingeschaltet sind und der Betrag der erfassten Größe größer ist als der vorgegebene obere Schwellenwert (THR_H).

12. Verfahren nach einem der Ansprüche 8 bis 11, bei dem eine Unterbrechung zwischen dem ersten und dem zweiten Anschluss (A1, A2) erkannt wird, wenn das erste und das zweite Schaltelement (T1, T2) eingeschaltet sind und der Betrag der erfassten Größe kleiner ist als der vorgegebene untere Schwellenwert (THR_L).

13. Verfahren nach einem der Ansprüche 8 bis 12, bei dem die Halbbrückenschaltung einen Parallelwiderstand (Rp) umfasst, der elektrisch parallel zu der induktiven Last (L) angeordnet ist, und zu dem mindestens einen Erfassungszeitpunkt ein Signalpegel des ersten Anschlusses (A1) erfasst wird und ein Kurzschluss des ersten oder des zweiten Anschlusses (A1, A2) zu dem Bezugspotenzial (GND) erkannt wird, wenn nur das erste Schaltelement (T1) eingeschaltet ist und der erfasste Signalpegel dem Bezugspotenzial (GND) entspricht.

## Claims

1. Method for checking an inductive load (1) on an electromechanical transducer in a full-bridge circuit which comprises a first, second, third and fourth switching element (T1, T2, T3, T4), with the third and the second switching element (T3, T2) forming a first series circuit and the first and the fourth switching element (T1, T4) forming a second series circuit, and with the first and the second series circuit being arranged electrically in parallel with one another between a supply potential (Ubat) and a reference ground potential (GND), with the first and third switching element (T1, T3) being coupled to the supply potential (Ubat), and with the second and the fourth switching element (T2, T4) being coupled to the reference ground potential (GND), and with the inductive load (L) being electrically coupled at a first connection (A1) via a measurement resistor (Rm) to a center tap (K1) of the first series circuit, and being electrically coupled at a second connection (A2) to a center tap (K2) of the second series circuit, and in which method
- the check comprises at least one measurement process,
- within the at least one measurement process, in each case either only the second or only the third switching element (T2, T3) is switched on or only the first and the second switching element (T1, T2) are switched on, or only the third and the fourth switching element (T3, T4) are switched on,
- at at least one detection time within the respective measurement process, a variable is detected which is representative of an electric current (I) which is flowing through the measurement resistor (Rm),
- a fault or soundness of the inductive load (L) in the full-bridge circuit is identified depending on the detected variable and the respectively switched-on switching element or the respectively switched-on switching elements, and
- a time period for the check is predetermined such that it is less than a minimum time period for which a minimum current level must flow through the inductive load (L) for a deflection of the electromechanical transducer from its rest position, such that the electromechanical transducer remains in the rest position throughout this time period.

2. Method according to Claim 1, in which shorting of the first connection (A1) to the supply potential (Ubat) is identified when only the second switching element (T2) is switched on and the magnitude of the detected variable is greater than a predetermined upper threshold value (THR_H).

3. Method according to one of the preceding claims, in which shorting of the second connection (A2) to the supply potential (Ubat) is identified when only the second switching element (T2) is switched on and the magnitude of the detected variable is greater than a predetermined lower threshold value (THR_L) and less than the predetermined upper threshold value (THR_H).

4. Method according to one of the preceding claims, in which shorting of the first connection (A1) to the reference ground potential (GND) is identified when only the third switching element (T3) is switched on and the magnitude of the detected variable is greater than the predetermined upper threshold value (THR_H).

5. Method according to one of the preceding claims, in which shorting of the second connection (A2) to the reference ground potential (GND) is identified when only the third switching element (T3) is switched on and the magnitude of the detected variable is greater than the predetermined lower threshold value (THR_L) and less than the predetermined upper threshold value (THR_H).

6. Method according to one of the preceding claims, in which shorting between the first and the second connection (A1, A2) is identified when only the first and the second switching element (T1, T2) or only the third and the fourth switching element (T3, T4) are switched on, and the magnitude of the detected variable is greater than the predetermined upper threshold value (THR_H).

7. Method according to one of the preceding claims, in which an interruption between the first and second connection (A1, A2) is identified when only the first and the second switching element (T1, T2) or only the third and the fourth switching element are switched on, and the magnitude of the detected variable is less than the predetermined lower threshold value (THR_L).

8. Method for checking an inductive load (L) on an electromechanical transducer in a half-bridge circuit which comprises a first and a second switching element (T1, T2), with the first switching element (T1) being coupled to the supply potential (Ubat) and with the second switching element (T2) being coupled to the reference ground potential (GND), and with the inductive load (L) being electrically coupled at a first connection (A1) via a measurement resistor (Rm) to the second switching element (T2), and being electrically coupled at a second connection (A2) to the first switching element (T1), and in which method
- the check comprises at least one measurement process,
- within the at least one measurement process, in each case only the second switching element (T2) is switched on or the first and the second switching element (T1, T2) are switched on,
- at at least one detection time within the respective measurement process, a variable is detected which is representative of an electric current (I) which is flowing through the measurement resistor (Rm),
- a fault or soundness of the inductive load (L) in the half-bridge circuit is identified depending on the detected variable and the respectively switched-on switching element or the respectively switched-on switching elements, and
- a time period for the check is predetermined such that it is less than a minimum time period for which a minimum current level must flow through the inductive load (L) for a deflection of the electromechanical transducer from its rest position, such that the electromechanical transducer remains in the rest position throughout this time period.

9. Method according to Claim 8, in which shorting of the first connection (A1) to the supply potential (Ubat) is identified when only the second switching element (T2) is switched on and the magnitude of the detected variable is greater than a predetermined upper threshold value (THR_H).

10. Method according to one of Claims 8 or 9, in which shorting of the second connection (A2) to the supply potential (Ubat) is identified when only the second switching element (T2) is switched on and the magnitude of the detected variable is greater than a predetermined lower threshold value (THR_L) and less than the predetermined upper threshold value (THR_H).

11. Method according to one of Claims 8 to 10, in which shorting between the first and the second connection (A1, A2) is identified when the first and the second switching element (T1, T2) are switched on and the magnitude of the detected variable is greater than the predetermined upper threshold value (THR_H).

12. Method according to one of Claims 8 to 11, in which an interruption between the first and the second connection (A1, A2) is identified when the first and second switching element (T1, T2) are switched on and the magnitude of the detected variable is less than the predetermined lower threshold value (THR_L).

13. Method according to one of Claims 8 to 12, in which the half-bridge circuit has a parallel resistor (Rp) which is arranged electrically in parallel with the inductive load, and a signal level at the first connection (A1) is detected at the at least one detection time, and shorting of the first or of the second connection (A1, A2) to the reference ground potential (GND) is identified when only the first switching element (T1) is switched on and the detected signal level corresponds to the reference ground potential (GND).

## Revendications

1. Procédé permettant de vérifier une charge inductive (L) d'un convertisseur électromécanique à l'aide d'un circuit en pont complet comprenant un premier, un deuxième, un troisième et un quatrième élément logique (T1, T2, T3, T4), où le troisième et le deuxième élément logique (T3, T2) constituent un premier circuit en série et le premier et le quatrième élément logique (T1, T4) constituent un deuxième circuit en série et où le premier circuit en série et le deuxième circuit en série sont montés électriquement en parallèle l'un par rapport à l'autre entre un potentiel d'alimentation (Ubat) et un potentiel de référence (GND), où le premier et le troisième élément logique (T1, T3) sont connectés sur le potentiel d'alimentation (Ubat) et le deuxième et le quatrième élément logique (T2, T4) sont connectés sur le potentiel de référence (GND) et où la charge inductive (L) est connectée électriquement par une première borne (A1), à travers une résistance de mesure (Rm), à une prise médiane (K1) du premier circuit en série et est connectée électriquement par une deuxième borne (A2) à une prise médiane (K2) du deuxième circuit en série, procédé au cours duquel
- la vérification comprend au moins une opération de mesure,
- dans le cadre de chacune de la au moins une opération de mesure, ou bien seul le deuxième, ou bien seul le troisième élément logique (T2, T3) est mis sous tension ou bien seuls le premier et le deuxième élément logique (T1, T2) ou bien seuls le troisième et le quatrième élément logique (T3, T4) sont mis sous tension,
- à au moins un instant de saisie dans le cadre de l'opération de mesure respective, est saisie une grandeur, qui est représentative pour un courant électrique (I) circulant à travers la résistance de mesure (Rm),
- en fonction de la grandeur saisie et de l'élément logique respectif mis sous tension ou des éléments logiques respectifs mis sous tension, une erreur ou une absence d'erreur de la charge inductive (L) est reconnue dans le circuit en pont complet et
- une durée de vérification est fixée au préalable de telle sorte que celle-ci est inférieure à une durée minimum, pour laquelle une intensité minimum du courant doit traverser la charge inductive (L) pour parvenir à une déviation du convertisseur électromagnétique à partir de sa position de repos, si bien que, dans le cadre de cette durée, la position de repos du convertisseur électromagnétique est maintenue.

2. Procédé selon la revendication 1, au cours duquel un court-circuit entre la première borne (A1) et le potentiel de référence (Ubat) est reconnu lorsque seul le deuxième élément logique (T2) est mis sous tension et la valeur de la grandeur saisie est supérieure à une valeur donnée pour un seuil supérieur (TRH_H).

3. Procédé selon l'une des revendications précédentes, au cours duquel un court-circuit entre la deuxième borne (A2) et le potentiel d'alimentation (Ubat) est reconnu lorsque seul le deuxième élément logique (T2) est mis sous tension et la valeur de la grandeur saisie est supérieure à une valeur donnée pour un seuil inférieur (THR_L) et inférieure à la valeur donnée pour le seuil supérieur (TRH_H).

4. Procédé selon l'une des revendications précédentes, au cours duquel un court-circuit entre la première borne (A1) et le potentiel de référence (GND) est reconnu lorsque seul le troisième élément logique (T3) est mis sous tension et la valeur de la grandeur saisie est supérieure à la valeur donnée pour le seuil supérieur (TRH_H).

5. Procédé selon l'une des revendications précédentes, au cours duquel un court-circuit entre la deuxième borne (A2) et le potentiel de référence (GND) est reconnu lorsque seul le troisième élément logique (T3) est mis sous tension et la valeur de la grandeur saisie est supérieure à la valeur donnée pour le seuil inférieur (THR_L) et inférieure à la valeur donnée pour le seuil supérieur (TRH_H).

6. Procédé selon l'une des revendications précédentes, au cours duquel un court-circuit entre la première et la deuxième borne (A1, A2) est reconnu lorsque seul le premier et le deuxième élément logique (T1, T2) ou seuls le troisième et le quatrième élément logique (T3, T4) sont mis sous tension et la valeur de la grandeur saisie est supérieure à la valeur donnée pour le seuil supérieur (TRH_H).

7. Procédé selon l'une des revendications précédentes, au cours duquel une discontinuité entre la première et la deuxième borne (A1, A2) est reconnue lorsque seuls le premier et le deuxième élément logique (T1, T2) ou seuls le troisième et le quatrième élément logique sont mis sous tension et la valeur de la grandeur saisie est inférieure à la valeur donnée pour le seuil inférieur (TRH_L).

8. Procédé permettant de vérifier une charge inductive (L) d'un convertisseur électromécanique à l'aide d'un circuit en demi pont comprenant un premier et un deuxième élément logique (T1, T2), où le premier élément logique (T1) est connecté sur le potentiel d'alimentation (Ubat) et le deuxième élément logique (T2) est connecté sur le potentiel de référence (GND) et où la charge inductive (L) est connectée électriquement par une première borne (A1), à travers une résistance de mesure (Rm), avec le deuxième élément logique (T2) et est connectée électriquement par une deuxième borne (A2) avec le premier élément logique (A1), procédé au cours duquel
- la vérification comprend au moins une opération de mesure,
- dans le cadre de chacune de la au moins une opération de mesure, seul le deuxième élément logique (T2) est mis sous tension ou bien le premier et le deuxième élément logique (T1, T2) sont mis sous tension,
- à au moins un instant de saisie dans le cadre de l'opération de mesure respective, est saisie une grandeur, qui est représentative pour un courant électrique (I) circulant à travers la résistance de mesure (Rm),
- en fonction de la grandeur saisie et de l'élément logique respectif mis sous tension ou des éléments logiques respectifs mis sous tension, une erreur ou une absence d'erreur de la charge inductive (L) est reconnue dans le circuit en demi pont et
- une durée de vérification est prescrite de telle sorte que celle-ci est inférieure à une durée minimum, pour laquelle une intensité minimum du courant doit traverser la charge inductive (L) pour parvenir à une déviation du convertisseur électromagnétique à partir de sa position de repos, si bien que, dans le cadre de cette durée, la position de repos du convertisseur électromagnétique est maintenue.

9. Procédé selon la revendication 8, au cours duquel un court-circuit entre la première borne (A1) et le potentiel d'alimentation (Ubat) est reconnu lorsque seul le deuxième élément logique (T2) est mis sous tension et une valeur de la grandeur saisie est supérieure à une valeur donnée pour un seuil supérieur (TRH_H).

10. Procédé selon l'une des revendications 8 ou 9, au cours duquel un court-circuit entre la deuxième borne (A2) et le potentiel d'alimentation (Ubat) est reconnu lorsque seul le deuxième élément logique (T2) est mis sous tension et la valeur de la grandeur saisie est supérieure à une valeur donnée pour un seuil inférieur (TRH_L) et inférieure à une valeur donnée pour un seuil supérieur (TRH_H).

11. Procédé selon l'une des revendications 8 à 10, au cours duquel un court-circuit entre la première borne (A1) et la deuxième borne (A2) est reconnu lorsque le premier et le deuxième élément logique (T1, T2) sont mis sous tension et la valeur de la grandeur saisie est supérieure à la valeur donnée pour un seuil supérieur (TRH_H).

12. Procédé selon l'une des revendications 8 à 11, au cours duquel une discontinuité entre la première et la deuxième borne (A1, A2) est reconnue lorsque le premier et le deuxième élément logique (T1, T2) sont mis sous tension et la valeur de la grandeur saisie est inférieure à la valeur donnée pour le seuil inférieur (TRH_L).

13. Procédé selon l'une des revendications 8 à 12, au cours duquel le circuit en demi pont comprend une résistance en parallèle (Rp), qui est montée électriquement en parallèle sur la charge inductive (L), et pour lequel, à au moins un instant de saisie, un niveau de signal de la première borne (A1) est détecté et un court-circuit entre la première ou la deuxième borne (A1, A2) et le potentiel de référence (GND) est reconnu lorsque seul le premier élément logique (T1) est mis sous tension et le niveau de signal saisi correspond au potentiel de référence (GND).
